(19)

**Europäisches Patentamt**
**European Patent Office**
**Office européen des brevets**

(11) **EP 2 057 872 B1**

(12) **EUROPEAN PATENT SPECIFICATION**

(45) Date of publication and mention
of the grant of the patent:
**25.05.2011 Bulletin 2011/21**

(51) Int Cl.:
*H05K 7/20* (2006.01)    *H02J 9/06* (2006.01)
*G06F 1/30* (2006.01)

(21) Application number: **07804080.5**

(22) Date of filing: **29.08.2007**

(86) International application number:
**PCT/GB2007/003271**

(87) International publication number:
**WO 2008/025981 (06.03.2008 Gazette 2008/10)**

(54) **A DEVICE FOR SUPPLYING ELECTRICAL POWER AND COOLED AIR**

EINRICHTUNG ZUM LIEFERN VON ELEKTRISCHEM STROM UND GEKÜHLTER LUFT

DISPOSITIF D'ALIMENTATION EN COURANT ÉLECTRIQUE ET EN AIR REFROIDI

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **29.08.2006 GB 0616930**

(43) Date of publication of application:
**13.05.2009 Bulletin 2009/20**

(73) Proprietor: **It Construct Ltd**
**Wilmslow, SK9 4JW (GB)**

(72) Inventors:
• **COULTHURST, David**
**Wilmslow, SK9 4JW (GB)**
• **WOLGRAM, Rupert, Peter**
**Wilmslow, SK9 4JW (GB)**

(74) Representative: **Bray, Richard Anthony et al**
**Marks & Clerk LLP**
**Sussex House**
**83-85 Mosley Street**
**Manchester M2 3LG (GB)**

(56) References cited:
**WO-A-02/097599    US-A1- 2006 056 142**

## Description

The present invention relates to a device for supplying electrical power and cooled air to equipment. It is particularly suitable for providing electrical power and cooled air to electronic equipment, such as computing equipment.

In computer server rooms and data centre, it is necessary to provide adequate supplies of electrical power and cooled air. Continuing advances in technology, particularly in the field of computer servers, ensures that there is an increasing demand for electrical power. This also results in a increasing heat output by computing equipment resulting in a greater need for cooling. Increasing computer power density ensures that both the electrical power and the cooling requirements of a typical computer room are increasing.

It is known to provide in a single unit a supply of electrical power and a supply of cooled air. This may take the form of a cabinet in which the computing equipment is placed, incorporating air conditioning units and power supplies. Alternatively, it may take the form of a unit, which is designed to supply electrical power and air conditioning to computing equipment surrounding the unit in a computer room. Bach a device is known from WO 02/097599 A.

Typically, it is desirable to provide an uninterruptible power supply (UPS). This is to ensure that should the mains electricity be interrupted, power is maintained to the computing equipment. This protects the computing equipment from loss of data. Additionally, the UPS equipment provides some protection for the computing equipment against power spikes and irregular power supplies from the mains electricity supply. A UPS typically comprises a large battery, or array of batteries, connected to the mains electricity supply. Usually the mains electricity supply will be AC current, which is converted to DC current before being used to charge the battery. The DC output of the battery is then converted to an AC current suitable for supplying power to the computing equipment. While the mains electricity is connected the battery is continuously being charged. Should the mains electricity be temporarily disconnected the battery will supply power to the computing equipment. This allows sufficient time to safely switch off all of the computing equipment. Alternatively, the battery may provide time to start up a generator as an alternative source of electrical power, without affecting the computing equipment.

However, a significant problem with conventional uninterruptible power supplies is that there is not normally sufficient battery power to maintain the power to the air conditioning when the mains electricity is interrupted. Consequently, should the mains power be disconnected the air conditioning will stop functioning. The computing equipment will begin to heat up, potentially causing damage. If a generator backup is being used it may take tens of seconds or longer to initialise the generator. During this time, the computing equipment is at risk of damage through over heating.

Conventional computing UPS equipment could be designed to provide power to the air conditioning units when the mains electricity supply is interrupted. However, this would require a very much increased size of battery array to store sufficient power. This is both uneconomic, and wasteful of space.

It is an aim of embodiments of the present invention to obviate, or mitigate, one or more of the above identified problems. Specifically, it is an aim of embodiments of the present invention to provide a device for supplying electrical power and cooled air to equipment, which is resilient to interruptions in the mains electricity supply.

According to a first aspect of the present invention there is provided a device for supplying electrical power and cooled air to equipment, the device comprising: an uninterruptible power supply comprising a battery, arranged to supply power to the equipment, and a power supply unit, arranged to charge the battery from an external power supply; and a cooling system arranged to supply cooled air to the equipment; wherein the cooling system comprises a thermal store and a refrigeration unit arranged to cool the thermal store, and the external power supply is arranged to supply power to the refrigeration unit, such that if the external power supply is interrupted the thermal store will continue to cool the equipment.

By providing such a device, in the event of the external power supply being interrupted the battery will continue to supply power, and the cooling system will continue to cool the equipment, as the thermal store will absorb heat from the surroundings.

Preferably, the thermal store comprises a heat absorbent material in thermal contact with the external surrounding environment.

Preferably, the material comprises a mixture of water and an antifreeze substance.

Preferably, the antifreeze substance comprises ethylene glycol.

Preferably, the cooling system further comprises: a first conduit forming a closed loop containing a coolant fluid, arranged to be in thermal contact with the thermal store, to cool the coolant fluid; and a heat exchanger arranged to be in thermal contact with a part of the first conduit; wherein the heat exchanger is arranged to transfer heat from the ambient environment to the coolant fluid.

Preferably, the cooling system further comprises: a first pump, arranged to pump the coolant fluid within the first conduit; and a fan, arranged to circulate air from outside of the device, such that the circulated air is in thermal contact with the heat exchanger, and back out of the device; wherein the battery is arranged to supply power to the first pump and the fan.

Preferably, the cooling system further comprises a second conduit forming a closed loop containing a refrigeration fluid, arranged to be in thermal contact with the thermal store, to cool the thermal store.

Preferably, the refrigeration unit is arranged to cool the refrigeration fluid.

Preferably, the refrigeration unit comprises a compressor arranged to compress the refrigeration fluid.

Preferably, the cooling system further comprises a second pump, arranged to pump the refrigeration fluid within the second conduit, and the external power supply is arranged to supply power to the second pump.

Preferably, in use the compressor is arranged to be connected to a condenser outside of the device, for cooling of the compressor.

Preferably, the thermal store has a cooling capacity of at least 8kWh.

According to a second aspect of the present invention there is provided a method of supplying electrical power and cooled air to equipment, the method comprising providing at least one device for supplying electrical power and cooled air to equipment, said device comprising: an uninterruptible power supply comprising a battery, arranged to supply power to the equipment, and a power supply unit, arranged to charge the battery from an external power supply; and a cooling system, arranged to supply cooled air to the equipment, comprising a thermal store and a refrigeration unit arranged to cool the thermal store, and the external power supply being arranged to supply power to the refrigeration unit, such that if the external power supply is interrupted the thermal store will continue to cool the equipment.

Preferably, the method further comprises the steps of: calculating a number P equal to the power requirement of the equipment, divided by a predetermined amount of power that can be provided by the battery; calculating a number C equal to the excess heat output of the equipment, divided by a predetermined amount of cooling capacity that can be provided by the cooling system; calculating a number N equal to the greater of P and C, rounded up to the next integer; and wherein the number of devices provided is equal to N + X, where X is an integer.

X may equal 0. X may equal N. X may equal 1.

According to a third aspect of the present invention there is provided a method of supplying electrical power and cooled air to equipment, the method comprising operating a device comprising: an uninterruptible power supply comprising a battery providing power to the equipment, and a power supply unit arranged to charge the battery via an external power supply; and a cooling system providing cooled air to the equipment, comprising a thermal store and a refrigeration unit, the refrigeration unit cooling the thermal store and the refrigeration unit being powered by the external power supply, such that if the external power supply is interrupted the thermal store will continue to cool the equipment.

Other aims, and advantages, of embodiments of the present invention will be readily apparent from the following description.

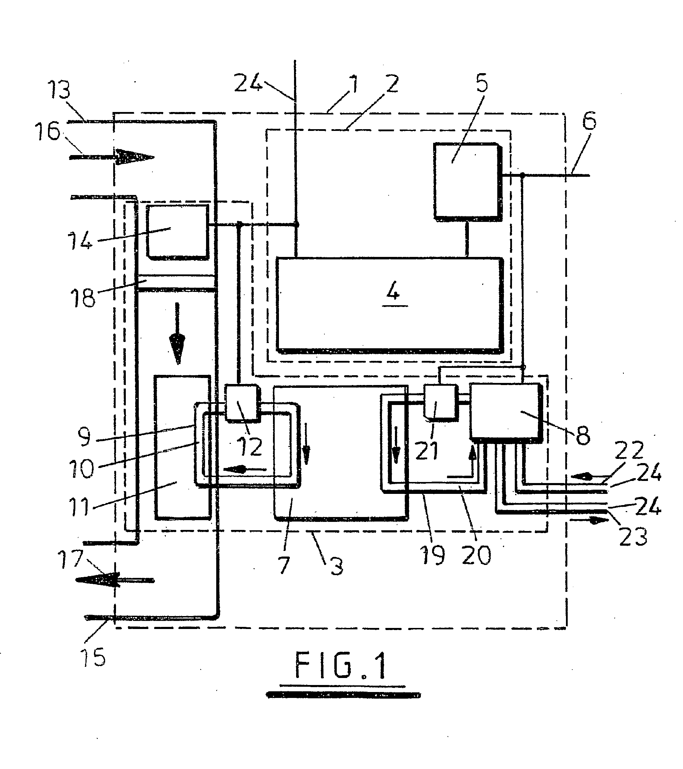

Specific embodiments of the present invention will now be described, by way of example only, with reference to the accompanying drawing in which Figure 1 is a schematic representation of a device for supplying electrical power and cooled air to equipment, in accordance with an embodiment of the present invention.

Referring to Figure 1, this illustrates a device 1, comprising an uninterruptible power supply 2 and a cooling system 3. The uninterruptible power supply 2 comprises a battery 4, arranged to supply power to the equipment via power cables 24, and a power supply unit 5 arranged to charge the battery 4 from the external power supply 6. The cooling system 3 comprises a thermal store 7 and a refrigeration unit 8, arranged to cool the thermal store 7. The refrigeration unit 8 is powered by the external power supply 6.

It is known to use a form of thermal store to provide air conditioning for offices. Such a thermal store comprises a large container filled with water and an anti-freeze substance. The container is normally located in the basement of the building due to the size and weight of the container. A refrigeration unit is used to freeze, or partially freeze, the thermal store. This freezing process is carried out at night when it is cheaper due to lower electricity costs. Additionally, the freezing process is more efficient at night, due to the lower ambient temperature. During the day time, air conditioning ducts pump air conditioning fluid through the thermal store, cooling the fluid down, and in the process melting the thermal store.

Due to this requirement for the thermal store to be frozen during the night and remelted during the day it is necessary to utilise a very large thermal store, typically 5-10 metres long and several metres high and wide. Furthermore, such thermal stores are most efficient when they have a very large volume to surface area ratio. This is because the rate of melting due to external heat sources is reduced with a large volume to surface area ratio.

The present inventors have realised that a much reduced size of thermal store has utility in forming part of an uninterruptible cooling system, for supplying cooled air to computing equipment. The thermal store 7 comprises a material able to absorb heat from the ambient environment. Preferably the thermal store 7 is able to absorb a relatively large amount of heat. This may be due to the material having a high specific heat capacity. Alternatively, it may be due to the material absorbing a large amount of latent heat when melting.

The latent heat of melting of a material is the amount of energy needed to be absorbed for the material to melt. Water is a suitable material for the thermal store as it has a high latent heat of melting. For water, the specific latent heat of melting is 334,000 $Jkg^{-1}$, i.e. it takes 334,000 J to melt one kg of ice. Within the thermal store 7, the energy required to melt the ice will be heat energy absorbed from the ambient environment. Thus, the thermal store cools the ambient environment as the ice melts. Energy absorption from the ambient environment through melting of the thermal store will provide the majority of the cooling. However, it will be appreciated that energy will continue to be absorbed from the ambient environment after the thermal store has melted as the material warms to the ambient temperature. Additionally, energy will be absorbed as the ice is heated from its cooled temperature to melting point. However, these processes are less efficient at absorbing heat. Therefore, the primary mechanism for absorbing heat energy from the ambient environment is the thermal store melting without relying on any further change in temperature of the thermal store.

The thermal store may consist of a container, containing water and an additional substance. It is convenient to use ethylene glycol as this additional substance. The additional substance (e.g. an antifreeze substance, such as ethylene glycol) is added to the water so as to increase the latent heat of melting for the thermal store, resulting in a more efficient process, and consequently requiring a smaller thermal store.

When the external power supply 6 is connected, the refrigeration unit is arranged to continuously cool the thermal store 7. Consequently, a very much smaller thermal store 7 may be used than is required for office air conditioning, where the thermal store is only frozen at night. It is this effect, which makes the use of such a cooling system particularly advantageous in the present invention. Consequently, the device 1 may be produced in a portable, ready assembled form for rapid provision of uninterruptible power and cooled air by a single integral unit.

The thermal store 7 may provide cooled air simply by ensuring that the ambient air around the device 1 comes into thermal contact with the thermal store 7. However, this process may be improved by ensuring that the warm air surrounding the device is passed over a heat exchanger connected to the thermal store. Figure 1 illustrates the cooling system 3 further comprising a first conduit 9 forming a closed loop containing a coolant fluid 10. The first conduit 9 is arranged to be in thermal contact with the thermal store 7. In Figure 1 this is shown by the first conduit 9 passing through part of the thermal store 7. This transfers heat from the coolant fluid 10 to the thermal store 7. A heat exchanger 11 is arranged to be in thermal contact with the first conduit 9. The heat exchanger 11 may comprise a conventional radiator through which the coolant fluid 10 passes. Alternatively, it may comprise an array of cooling fins formed from a material that conducts heat efficiently. The heat exchanger 11 is arranged to transfer heat from the ambient environment surrounding the device to the coolant fluid 10.

It is preferable to pump the coolant fluid 10 through the thermal store 7 to ensure that the heat is transferred efficiently from the ambient environment to the thermal store 7. For this purpose, a first pump 12 is provided which pumps coolant fluid 10 within the first conduit 9. The first pump 12 is preferably powered by the battery 4, ensuring that should the external power supply 6 be interrupted (e.g. fail), the power to the pump 12 is maintained. This allows the coolant fluid 10 to continue to pass through the thermal store 7 maintaining the cooling. The refrigeration unit 8 is preferably powered directly by the external power supply 6. Alternatively, the refrigeration unit 8 may be arranged to be powered by external power supply 6 via the battery 4 only when the external power supply provides power to the battery 4. The result of this is that if the external power supply 6 is interrupted the refrigeration unit 8 ceases refreezing/cooling the thermal store 7. However, during the period during which the external power supply 6 is interrupted the pump 12 continues to run ensuring that the cooled air supply is maintained.

A further preferable feature of the cooling system 3 is shown in Figure 1. Warm air from the ambient environment surrounding the device is drawn into the device via duct 13 by fan 14. Fan 14 is preferably powered by battery 4, such that it continues to operate even when the mains power supply is disconnected. Fan 14 blows warm air from the ambient environment surrounding the device 1 over the heat exchanger 11 and returns the cooled air to the outside of the device via duct 15. This flow of air through the device is schematically illustrated by arrows 16 and 17. Fan 14 may additionally incorporate an air filter 18 to prevent dust being drawn into the device.

In order for the refrigeration unit 8 to cool the thermal store 7 a second conduit 19 is provided forming a closed loop. Second conduit 19 contains a refrigeration fluid 20. The refrigeration fluid 20 is arranged to be in thermal contact with the thermal store 7, to cool the thermal store 7. Second conduit 19 passes through the refrigeration unit 8. The refrigeration unit 8 comprises a compressor, arranged to compress the refrigeration fluid 20. The act of compressing the refrigeration fluid 20 cools the refrigeration fluid 20. Therefore, as the second conduit 19 passes through the thermal store 7 heat is transferred from the thermal store 7 to the refrigeration fluid 20. The cooling system 3 further comprises a second pump 21, arranged to pump the refrigeration fluid 20 within the second conduit 19. The second pump 21 is preferably powered by the external power supply 6, as per the refrigeration unit 8.

The refrigeration unit 8 is connected to a condenser (not illustrated). Preferably, the condenser is situated away from the device. Conduits 22 and 23 transfer a refrigeration fluid 24 between the refrigeration unit and the condenser. This condenser dissipates heat removed from the ambient environment around the device 1.

A device for supplying electrical power and cooled air in accordance with an embodiment of the present invention will typically be provided in a single transportable unit. Such a unit can be assembled away from the operational site and provided in a form capable of commencing operation after a very short set up period.

In order to provide electrical power and cooled air to a computer room it may typically be necessary to provide a system comprising a plurality of devices in accordance with the present invention. The number of devices to be provided may be determined as follows:

1) Calculate a number P, where P is equal to the total power requirement of the equipment (e.g. the computer room), divided by the known power that may be provided by the battery of a single device.
2) Calculate a number C, where C is equal to the total excess heat output of the equipment, divided by the known cooling capacity of the cooling system of a single device.
3) Calculate a number N, where N is equal to the greater of P and N rounded up to the next integer.
4) Provide a number of devices equal to N+X.

If X=0 then the number of devices will be the minimum necessary to power and cool the computer room. If X=1 then one redundant unit is provided, allowing the system to be tolerant to the failure of a single unit. If X=N then this provides complete redundancy, which may be necessary for mission critical computing applications.

The battery will be sized such that in the event of the external power supply being interrupted the UPS will be able to continue to supply electrical power to the equipment for a first predetermined time period. The thermal store will be sized such that the cooling system will be able to continue to cool the equipment for a second predetermined time period, which may be different to the first predetermined time period.

Typically, the UPS 2 is designed to be capable of supplying 1 hours battery backup, (i.e. to provide the required power to the equipment for 1 hour) without the need for generator backup. However, it will be readily appreciated by the appropriately skilled person that a device in accordance with the present invention could additionally be supplied with an input for a generator, to provide a second source of electrical power. Further, it will be readily appreciated that the generator may be used to power to cooling system 3, such that the supply of cooled air is maintained. Alternatively, a separate backup cooling system may be provided.

The size of thermal store needed to cool the ambient environment for one hour during an interruption in the external power supply may be calculated as follows.

Firstly, for convenience it is assumed that the primary mechanism whereby the thermal store absorbs energy from the ambient environment, (thus cooling the ambient environment), is through the latent heat of melting of the thermal store. Additionally, for convenience, the latent heat of melting of water will be used. It will be appreciated that in practice an additional substance would preferably be added to the water, increasing the latent heat of melting, and resulting in a smaller thermal store being required. However, the precise additional substance used may vary.

The likely heat output of the computing equipment to be cooled is established. A computer room powered and cooled by a device in accordance with an embodiment of the present invention may typically consume 9kW of electrical power. This electrical power is predominantly converted into heat energy. Therefore, for the purposes of these calculations 9kW will be assumed to be the required cooling capacity per unit time of the device. It will be appreciated, however, that embodiments of the present invention may be constructed with thermal stores in a range of sizes depending upon the application for which they are required.

The energy transferred from a material on melting, E (J) may be calculated as follows:

$E = L*M$

where L is the latent heat of melting of the material ($J.kg^{-1}$) and M is the mass of material (kg).

Energy transferred E may be expressed as:

$E = P*t$

where P is the power required by the material melting (W) and t is time (s).

Therefore:

$M = P*t/L$

The latent heat of melting for water is 334,000 $J.kg^{-1}$. Based on a required cooling capacity of 9kW for one hour of cooling, the required mass of ice can be calculated as follows:

$M = 9,000*3600/334,000 = 97kg$

However, these calculations do not take account of the absorption of heat through the walls of the thermal store (i.e. from the ambient environment, rather than the computing equipment). This can deplete the ability of the thermal store to provide the desired amount of heat energy absorption. The degree of heat loss is dependent upon the surface area of the thermal store, the temperature difference between the ice and the ambient environment and the resistivity of any insulation surrounding the thermal store. An insulator with a low thermal conductivity should be used to minimise any losses through the walls of the thermal store.

The rate of heat loss $P_L$ (W) from the thermal store may be expressed as:

$$P_L = A*T/(R_S+R_I)$$

where A is the surface area of the block of ice ($m^2$), T is the temperature difference between ambient temperature and the thermal store (°C), $R_S$ is the thermal resistance of the surface of the block of ice and $R_1$ is the thermal resistance of the insulator.

For a cube of 97kg of water the surface area is approximately 1.26m$^2$. The temperature difference between a typical computer room environment and the block of ice at 0°C will be approximately 22°C.

The thermal resistance of the surface of the block of ice is typically 0.304 m$^2$°C/W. The thermal resistance of the insulator may be calculated as follows:

$$R_I = D/K = 0.025/0.02 = 1.25 \text{ m}^2\text{°C/W}$$

where D is the thickness of the insulator (m), which is typically 25mm, and K is the thermal conductivity of the insulator (W/(m.°C)), which for an insulator is typically 0.02W/(m.°C).

Therefore the rate of heat loss $P_L$ from the thermal store is equal to:

$$P_L = 1.26*22/(0.304+1.25) = 22.8\text{W}.$$

Over a 24 hour time period t, assuming no refreezing of the thermal store, the amount of additional water need to compensate for this heat loss may be calculated as follows:

$$M = P*t/L = 22.8*24*3600/334,000 = 6\text{kg}$$

Therefore, it is desirable to allow an extra 6kg of water/ice, i.e.103kg to allow for extended periods during which the thermal store is not refrozen, and still provide a sufficient amount of heat absorption capacity to cope with an interruption in the external power supply for 1 hour. However, more commonly, except during an interruption in the external power supply, the thermal store will be continually refrozen.

It will be readily appreciated by the appropriately skilled person that the supply of cooled air from the device may be connected to appropriate ducting within a computer room or data centre environment to supply the cooled air to the point at which it is needed. Such ducting may include passing the cooled air underneath a plenum floor such that the cooled air is passed up through racks of computer equipment.

It will be readily apparent to the appropriately skilled person that it may be necessary to provide additionally switch gear equipment so that the uninterruptible power supply from the battery may be connected to a range of equipment at the correct voltage. Additionally, it will be readily apparent to the appropriately skilled person that it may be necessary to convert the electrical power supply from the battery to provide an AC current source.

The present invention has been primarily described as supplying electrical power and cooled air to electronic, and specifically computing equipment. It will be readily apparent to the appropriately skilled person that embodiments of the present invention may be utilised to provide uninterruptible electrical power and cooled air supplies to any form of equipment.

Further modifications, and applications, of the present invention will be readily apparent to the appropriately skilled person, without departing from the scope of the appended claims.

**Claims**

1. A device for supplying electrical power and cooled air to equipment, the device comprising:

   an uninterruptible power supply (2) comprising a battery (4), arranged to supply power to the equipment, and a power supply unit (5), arranged to charge the battery from an external power supply (6), and
   a cooling system (3) arranged to supply cooled air to the equipment; **characterized in that** the cooling system comprises a thermal store (7) and a refrigeration unit (8) arranged to cool the thermal store, and the external power supply (6) is arranged to supply power to the refrigeration unit (8), such that if the external power supply (6) is interrupted the thermal store will continue to cool the equipment.

2. A device according to claim 1, wherein the thermal store comprises a heat absorbent material in thermal contact with the external surrounding environment.

3. A device according to claim 2, wherein the material comprises a mixture of water and an antifreeze substance.

4. A device according to claim 3, wherein the antifreeze substance comprises ethylene glycol.

5. A device according to any one of the preceding claims, wherein the cooling system further comprises:

a first conduit (9) forming a closed loop containing a coolant fluid, arranged to be in thermal contact with the thermal store, to cool the coolant fluid; and
a heat exchanger (11) arranged to be in thermal contact with a part of the first conduit;
wherein the heat exchanger is arranged to transfer heat from the ambient environment to the coolant fluid.

6. A device according to claim 5, wherein the cooling system further comprises:

a first pump (12), arranged to pump the coolant fluid within the first conduit; and
a fan (14), arranged to circulate air from outside of the device, such that the circulated air is in thermal contact with the heat exchanger, and back out of the device;
wherein the battery (4) is arranged to supply power to the first pump (12) and the fan (14).

7. A device according to any one of the preceding claims, wherein the cooling system further comprises a second conduit (19) forming a closed loop containing a refrigeration fluid, arranged to be in thermal contact with the thermal store, to cool the thermal store.

8. A device according to claim 7, wherein the refrigeration unit is arranged to cool the refrigeration fluid.

9. A device according to claim 8, wherein the refrigeration unit comprises a compressor arranged to compress the refrigeration fluid.

10. A device according to any one of claims 7 to 9, wherein the cooling system further comprises a second pump (21) arranged to pump the refrigeration fluid within the second conduit (19) and the external power supply is arranged to supply power to the second pump.

11. A device according to claim 9 or to claim 10, wherein in use the compressor is arranged to be connected to a condenser outside of the device, for cooling the compressor.

12. A method of supplying electrical power and cooled air to equipment, the method comprising providing or opperating at least one device according to claim 1 for supplying electrical power and cooled air to said equipment.

13. A method according to claim 12, further comprising the steps of:

a) calculating a number P equal to the power requirement of the equipment, divided by a predetermined amount of power that can be provided by the battery;
b) calculating a number C equal to the heat output of the equipment, divided by a predetermined amount of cooling capacity that can be provided by the cooling system;
c) calculating a number N equal to the greater of P and C, rounded up to the next integer; and
d) wherein the number of devices provided is equal to N + X, where X is an integer.

14. A method according to claim 13, wherein X equals 0, or wherein X equals N, or wherein X equals 1.

**Patentansprüche**

1. Vorrichtung zum Liefern von elektrischem Strom und gekühlter Luft zu einer Anlage, wobei die Vorrichtung aufweist:

eine unterbrechungsfreie Stromversorgung (2), die eine Batterie (4), die angeordnet ist, um Strom der Anlage zuzuführen, und eine Stromversorgungseinheit (5) aufweist, die angeordnet ist, um die Batterie von einer externen Stromversorgung (6) aus aufzuladen; und
ein Kühlsystem (3), das angeordnet ist, um der Anlage gekühlte Luft zuzuführen; **dadurch gekennzeichnet, dass**

das Kühlsystem einen Wärmespeicher (7) und ein Kälteaggregat (8) aufweist, das angeordnet ist, um den Wärmespeicher zu kühlen, und dass die externe Stromversorgung (6) angeordnet ist, um dem Kälteaggregat (8) Strom zuzuführen, so dass, wenn die externe Stromversorgung (6) unterbrochen wird, der Wärmespeicher weiter die Anlage kühlen wird.

2. Vorrichtung nach Anspruch 1, bei der der Wärmespeicher ein wärmeabsorbierendes Material in Wärmekontakt mit der externen Umgebung aufweist.

3. Vorrichtung nach Anspruch 2, bei der das Material eine Mischung aus Wasser und einer Gefrierschutzsubstanz aufweist.

4. Vorrichtung nach Anspruch 3, bei der die Gefrierschutzsubstanz Ethylenglykol aufweist.

5. Vorrichtung nach einem der vorhergehenden Ansprüche, bei der das Kühlsystem außerdem aufweist:

einen ersten Kanal (9), der einen geschlossenen Kreis bildet, der ein Kühlmittelfluid enthält, so angeordnet, dass er mit dem Wärmespeicher in Wärmekontakt ist, um das Kühlmittelfluid abzukühlen; und einen Wärmetauscher (11), der angeordnet ist, um mit einem Teil des ersten Kanals in Wärmekontakt zu sein; wobei der Wärmetauscher angeordnet ist, um Wärme aus der umgebenden Umwelt zum Kühlmittelfluid zu übertragen.

6. Vorrichtung nach Anspruch 5, bei der das Kühlsystem außerdem aufweist:

eine erste Pumpe (12), die angeordnet ist, um das Kühlmittelfluid innerhalb des ersten Kanals zu pumpen; und einen Ventilator (14), der angeordnet ist, um Luft von außerhalb der Vorrichtung zum Zirkulieren zu bringen, so dass die zirkulierte Luft in Wärmekontakt mit dem Wärmetauscher ist, und zurück aus der Vorrichtung heraus; wobei die Batterie (4) angeordnet ist, um der ersten Pumpe (12) und dem Ventilator (14) Strom zuzuführen.

7. Vorrichtung nach einem der vorhergehenden Ansprüche, bei der das Kühlsystem außerdem einen zweiten Kanal (19) aufweist, der einen geschlossenen Kreis bildet, der ein Kältefluid enthält, so angeordnet, dass er mit dem Wärmespeicher in Wärmekontakt ist, um den Wärmespeicher zu kühlen.

8. Vorrichtung nach Anspruch 7, bei der das Kälteaggregat angeordnet ist, um das Kältefluid zu kühlen.

9. Vorrichtung nach Anspruch 8, bei der das Kälteaggregat einen Kompressor aufweist, der angeordnet ist, um das Kältefluid zu komprimierten.

10. Vorrichtung nach einem der Ansprüche 7 bis 9, bei der das Kühlsystem außerdem eine zweite Pumpe (21) aufweist, die angeordnet ist, um das Kältefluid innerhalb des zweiten Kanals (19) zu pumpen, und wobei die externe Stromversorgung angeordnet ist, um der zweiten Pumpe Strom zuzuführen.

11. Vorrichtung nach Anspruch 9 oder nach Anspruch 10, bei der bei Benutzung der Kompressor so angeordnet ist, dass er mit einem Kühler außerhalb der Vorrichtung für das Kühlen des Kompressors verbunden ist.

12. Verfahren zum Liefern von elektrischem Strom und gekühlter Luft zu einer Anlage, wobei das Verfahren den folgenden Schritt aufweist: Bereitstellen oder Betätigen von mindestens einer Vorrichtung nach Anspruch 1 zum Liefern von elektrischem Strom und gekühlter Luft zu der Anlage.

13. Verfahren nach Anspruch 12, das außerdem die folgenden Schritte aufweist:

a) Berechnen einer Zahl P gleich dem Strombedarf der Anlage, dividiert durch eine vorher bestimmte Strommenge, die von der Batterie bereitgestellt werden kann;
b) Berechnen einer Zahl C gleich der Wärmeabgabe der Anlage, dividiert durch eine vorgegebene Größe der Kühlleistung, die vom Kühlsystem bereitgestellt werden kann;
c) Berechnen einer Zahl N gleich dem größeren von P und C, aufgerundet auf die nächste ganze Zahl; und
d) wobei die Anzahl der bereitgestellten Vorrichtungen gleich N + X ist, worin X eine ganze Zahl ist.

14. Verfahren nach Anspruch 13, bei dem X gleich O ist, oder bei dem X gleich N ist, oder bei dem X gleich 1 ist.

**EP 2 057 872 B1**

**Revendications**

1. Dispositif agencé pour assurer l'alimentation en énergie et en air refroidi d'un équipement, le dispositif comprenant :

une alimentation en énergie sans coupure (2), comprenant une batterie (4) agencée pour assurer l'alimentation en énergie de l'équipement, et une unité d'alimentation en énergie (5), agencée pour charger la batterie à partir d'une alimentation en énergie externe (6); et
un système de refroidissement (3), agencé pour alimenter l'équipement en air refroidi, **caractérisé en ce que** le système de refroidissement comprend un accumulateur thermique (7) et une unité de réfrigération (8), agencée pour refroidir l'accumulateur thermique, l'alimentation en énergie externe (6) étant agencée pour assurer l'alimentation en énergie de l'unité de réfrigération (8), de sorte que lors d'une coupure de l'alimentation en énergie externe (6), l'accumulateur thermique poursuivra le refroidissement de l'équipement.

2. Dispositif selon la revendication 1, dans lequel l'accumulateur thermique comprend un matériau à absorption de la chaleur, en contact thermique avec l'environnement externe environnant.

3. Dispositif selon la revendication 2, dans lequel le matériau comprend un mélange d'eau et d'une substance antigel.

4. Dispositif selon la revendication 3, dans lequel la substance antigel comprend de l'éthylène glycol.

5. Dispositif selon l'une quelconque des revendications précédentes, dans lequel le système de refroidissement comprend en outre :

un premier conduit (9), formant une boucle fermée contenant un fluide de refroidissement, agencé de sorte à être en contact thermique avec l'accumulateur thermique afin de refroidir le fluide de refroidissement; et
un échangeur de chaleur (11), agencé de sorte à être en contact thermique avec une partie du premier conduit ; l'échangeur de chaleur étant agencé pour assurer le transfert de la chaleur de l'environnement ambiant vers le fluide de refroidissement :

6. Dispositif selon la revendication 5, dans lequel le système de refroidissement comprend en outre :

une première pompe (12), agencée pour pomper le fluide de refroidissement dans le premier conduit ; et
un ventilateur (14), agencé pour assurer la circulation de l'air à partir de l'extérieur du dispositif, de sorte que l'air en circulation est en contact thermique avec l'échangeur de chaleur, et vers l'arrière, hors du dispositif; la batterie (4) étant agencée pour assurer l'alimentation en énergie de la première pompe (12) et du ventilateur (14).

7. Dispositif selon l'une quelconque des revendications précédentes, dans lequel le système de refroidissement comprend en outre un deuxième conduit (19), formant une boucle fermée contenant un fluide de réfrigération, agencé de sorte à être en contant thermique avec l'accumulateur thermique, afin de refroidir l'accumulateur thermique.

8. Dispositif selon la revendication 7, dans lequel l'unité de réfrigération est agencée pour refroidir le fluide de réfrigération.

9. Dispositif selon la revendication 8, dans lequel l'unité de réfrigération comprend un compresseur, agencé pour comprimer le fluide de réfrigération.

10. Dispositif selon l'une quelconque des revendications 7 à 9, dans lequel le système de refroidissement comprend en outre une deuxième pompe (21), agencée pour pomper le fluide de réfrigération dans le deuxième conduit (19), l'alimentation en énergie externe étant agencée pour assurer l'alimentation en énergie de la deuxième pompe.

11. Dispositif selon les revendications 9 ou 10, dans lequel le compresseur est agencé en service de sorte à être connecté à un condenseur à l'extérieur du dispositif, pour refroidir le compresseur.

12. Procédé d'alimentation en énergie électrique et en air refroidi d'un équipement, le procédé comprenant l'étape de fourniture ou d'actionnement d'au moins un dispositif selon la revendication 1, pour assurer l'alimentation en énergie électrique et en air refroidi dudit équipement.

9

**13.** Procédé selon la revendication 12, comprenant en outre les étapes ci-dessous :

a) calcul d'un nombre P égal aux besoins en énergie de l'équipement, divisé par une quantité prédéterminée d'énergie pouvant être fournie par la batterie ;
b) calcul d'un nombre C, égal à la puissance thermique de l'équipement, divisé par une quantité prédéterminée de la capacité de refroidissement pouvant être assurée par le système de refroidissement :
c) calcul d'un nombre N, égal ou supérieur aux nombres P et C, arrondi au nombre entier suivant ; et
d) le nombre de dispositifs fournis étant égal à N + X, X représentant un nombre entier.

**14.** Procédé selon la revendication 13, dans lequel X est égal à 0, ou dans lequel X est égal à N, ou dans lequel X est égal à 1.

FIG.1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02097599 A